# EUROPEAN PATENT APPLICATION

(11) **EP 4 684 667 A1**
(43) Date of publication of application: **28.01.2026**
(21) Application number: 24796049.5
(22) Date of filing: 23.04.2024
(51) Int. Cl.: A24F 40/50, G01R 31/388, A24F 40/90

(54) **AEROSOL GENERATION APPARATUS AND CONTROL METHOD**

(30) Priority: 25.04.2023 CN 202310472217
(71) Applicant: Shenzhen First Union Technology Co., Ltd., Shenzhen, Guangdong 518000 (CN)
(72) Inventor: YANG, Wenhao, Shenzhen, Guangdong 518000 (CN); XU, Zhongli, Shenzhen, Guangdong 518000 (CN); LI, Yonghai, Shenzhen, Guangdong 518000 (CN)
(74) Representative: Ran, Handong
(86) International application number: PCT/CN2024/089295
(87) International publication number: WO 2024/222669

(57) **Abstract**

An aerosol generation apparatus and a control method. The aerosol generation apparatus comprises a heater (10), a battery cell (20), a charging circuit and a controller, wherein the controller is configured to: acquire an initial voltage of the battery cell (20) when the battery cell starts to be charged; determine whether the initial voltage of the battery cell (20) is in one or more preset timing reference voltage intervals; and if the initial voltage of the battery cell (20) is in one timing reference voltage interval, according to a preset duration corresponding to the timing reference voltage interval, control the charging circuit to charge the battery cell (20), and when the charging duration for the battery cell (20) reaches the preset duration, control the charging circuit to stop charging the battery cell (20). Therefore, it is effectively ensured that a battery is fully charged but is not overcharged, thereby improving the endurance ability of the battery.

## Description

### CROSS-REFERENCE TO RELATED APPLICATIONS

This application claims priority to Chinese Patent Application No. 202310472217.1, filed with the China National Intellectual Property Administration on April 25, 2023 and entitled "AEROSOL GENERATING DEVICE AND CONTROL METHOD", which is incorporated herein by reference in its entirety.

### TECHNICAL FIELD

This application relates to the field of electronic atomization technologies, and in particular, to an aerosol generating device and a control method.

### BACKGROUND

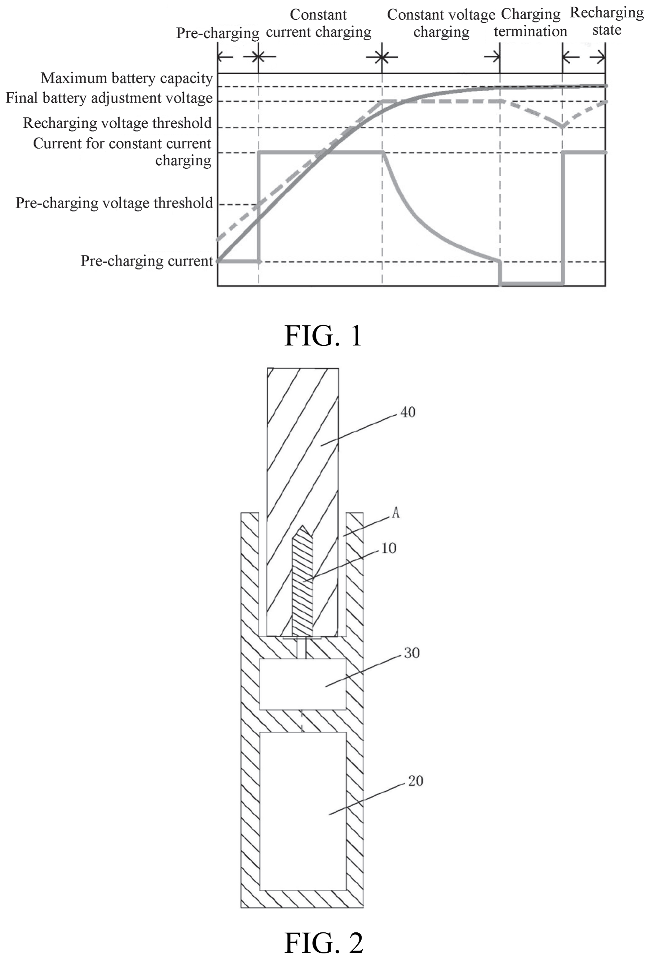

An existing aerosol generating device generally has a rechargeable battery, for example, a lithium-ion battery. The lithium-ion battery is charged through a charging chip after being electrically connected to an external power supply through a charging interface. As shown in FIG. 1, a process of charging a lithium battery may be divided into four stages: a pre-charging stage, a constant current charging stage, a constant voltage charging stage, and a charging termination stage.

In the related art, inability to accurately determine whether a battery is fully charged easily leads to battery overcharging or insufficient charging, thereby reducing endurance of the battery.

### SUMMARY

Embodiments of this application are intended to provide an aerosol generating device and a control method, to resolve a problem in the related art that inability to accurately determine whether a battery is fully charged leads to battery overcharging or insufficient charging, thereby reducing endurance of the battery.

To resolve the foregoing technical problem, the embodiments of this application provide the following technical solutions.

According to an aspect of this application, an aerosol generating device is provided, including:
a heater, configured to atomize an aerosol-forming substrate to generate an aerosol;
a battery core, configured to supply electric power to the heater;
a charging circuit, configured to charge the battery core; and
a controller, configured to obtain an initial voltage of the battery core when the battery core starts to be charged; determine whether the initial voltage of the battery core is within one or more preset timing reference voltage ranges; and if the initial voltage of the battery core is within one of the timing reference voltage ranges, control, based on a preset duration corresponding to the timing reference voltage range, the charging circuit to charge the battery core, and control the charging circuit to stop charging the battery core when a charging duration of the battery core reaches the preset duration.

In an example, the controller is configured to control the charging circuit to charge the battery core with a pre-charging current or a constant current if the initial voltage is not within the one or more timing reference voltage ranges.

In an example, the controller is configured to: when the charging circuit charges the battery core with the pre-charging current or the constant current, control, if a voltage of the battery core rises to be within one of the timing reference voltage ranges, the charging circuit to continue charging the battery core based on the preset duration corresponding to the timing reference voltage range, and control the charging circuit to stop charging the battery core when a continued charging duration of the battery core reaches the preset duration.

In an example, the one or more timing reference voltage ranges are between a pre-charging voltage threshold of the battery core and a final battery adjustment voltage.

In an example, two adjacent timing reference voltage ranges of the plurality of timing reference voltage ranges share a common endpoint.

In an example, a difference between an upper limit value and a lower limit value of the timing reference voltage range is in a range of 0.01V to 0.2V.

In an example, among the plurality of timing reference voltage ranges, different timing reference voltage ranges correspond to different preset durations.

In an example, the controller is configured to set a preset battery level indicator to a full charge indicator when the charging circuit is controlled to stop charging the battery core.

In an example, the controller is configured to obtain the battery level indicator before the battery core starts to be charged; and control the charging circuit to stop charging the battery core if the battery level indicator is the full charge indicator.

In an example, the controller is configured to generate prompt information if the battery level indicator is the full charge indicator, to prompt that the battery core is in a fully charged state.

In an example, the aerosol generating device further includes a detection circuit, configured to detect a voltage of the battery core; and
the controller is configured to obtain the initial voltage of the battery core through the detection circuit when the charging circuit starts to charge the battery core.

According to another aspect of this application, a control method for an aerosol generating device is provided. The aerosol generating device includes a heater, configured to atomize an aerosol-forming substrate to generate an aerosol; a battery core, configured to supply electric power to the heater; and a charging circuit, configured to charge the battery core; and the control method includes:
obtaining an initial voltage of the battery core when the battery core starts to be charged;
determining whether the initial voltage of the battery core is within one or more preset timing reference voltage ranges; and
if the initial voltage of the battery core is within one of the timing reference voltage ranges, controlling, based on a preset duration corresponding to the timing reference voltage range, the charging circuit to charge the battery core, and controlling the charging circuit to stop charging the battery core when a charging duration of the battery core reaches the preset duration.

The embodiments of this application have the following beneficial effects: Different from the situation in the prior art, in the embodiments of this application, the controller of the aerosol generating device is configured to obtain the initial voltage of the battery core when the battery core starts to be charged, and if the initial voltage is within one of the preset timing reference voltage ranges, control the charging circuit to charge the battery core based on the preset duration corresponding to the timing reference voltage range, and control the charging circuit to stop charging the battery core when the charging duration reaches the preset duration. According to this application, one or more timing reference voltage ranges and the corresponding preset duration are preset, so that it can be effectively ensured that a battery is fully charged and is not overcharged, thereby improving the endurance of the battery.

### BRIEF DESCRIPTION OF THE DRAWINGS

One or more embodiments are exemplarily described with reference to pictures in accompanying drawings corresponding to the embodiments, and the exemplary descriptions do not constitute a limitation on the embodiments. Elements in the accompanying drawings that have same reference numerals are represented as similar elements, and unless otherwise particularly stated, the figures in the accompanying drawings do not constitute a scale limitation.
FIG. 1 is a schematic diagram of a charging process of a lithium battery according to this application.
FIG. 2 is a schematic structural diagram of an aerosol generating device according to an embodiment of this application.

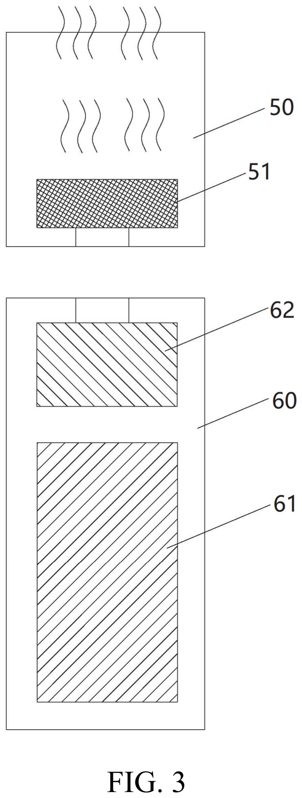

FIG. 3 is a schematic structural diagram of another aerosol generating device according to an embodiment of this application.
FIG. 4 is a flowchart of a control method for an aerosol generating device according to an embodiment of this application.

### DETAILED DESCRIPTION

To make objectives, technical solutions, and advantages of embodiments of this application clearer, the technical solutions in the embodiments of this application are to be clearly and completely described below with reference to the accompanying drawings in the embodiments of this application. Apparently, the embodiments to be described are a part rather than all of the embodiments of this application. All other embodiments obtained by a person of ordinary skill in the art based on the embodiments of the present application without creative efforts shall fall within the protection scope of the present application.

Technical features involved in implementations of this application that are described below may be combined with each other provided that no conflict occurs.

### Embodiment I

According to an embodiment of this application, an aerosol generating device is provided. As shown in FIG. 2, the aerosol generating device includes:
a chamber A, where an aerosol generating article 40 is removably received in the chamber A, the aerosol generating article 40 includes a solid aerosol-forming substrate, and the solid aerosol-forming substrate can generate an inhalable aerosol; and
a heater 10, where when the aerosol generating article 40 is received in the chamber A, the heater 10 is configured to heat and atomize the solid aerosol-forming substrate in the aerosol generating article 40 to generate an aerosol; in an example in the figure, the heater 10 is inserted into the aerosol generating article 40 for heating, which is generally referred to as central heating; and in another example, the heater 10 may perform heating by surrounding at least part of the aerosol generating article 40, which is generally referred to as circumferential heating;
a battery core 20, configured to supply electric power to the heater 10 and another component of the aerosol generating device; and
a circuit board 30, arranged between the battery core 20 and the heater 10. A charging circuit and a controller are integrated on the circuit board 30. The charging circuit is configured to charge the battery core 20. The controller is configured to control the aerosol generating device through a micro controller unit (MCU), an application-specific integrated circuit, or the like.

FIG. 2 shows another aerosol generating device provided according to an embodiment of this application. The aerosol generating device includes an atomizer 50 and a power supply assembly 60. The atomizer 50 is detachably connected to the power supply assembly 60. In another example, it is also feasible that the atomizer 50 and the power supply assembly 60 are non-detachably connected, that is, integrally formed.

The atomizer 50 includes a liquid storage cavity for storing an aerosol-forming substrate, and a heater 51. The heater 51 is configured to atomize the aerosol-forming substrate to form an inhalable aerosol under an action of electric power supplied by the power supply assembly 60. In the example, the aerosol-forming substrate is a liquid aerosol-forming substrate (that is, a liquid substrate). The heater 51 includes a resistive material. The resistive material may include, but is not limited to, a semiconductor, carbon, graphite, metal, a metal alloy, and a composite material formed by a ceramic material and a metal material.

The aerosol generating device may further include a liquid transfer unit. The liquid transfer unit may be made of, for example, cotton fiber, metal fiber, ceramic fiber, glass fiber, porous ceramic, or the like. The liquid aerosol-forming substrate stored in the liquid storage cavity may be transferred to the heater 51 through a capillary action.

The power supply assembly 60 includes a battery core 61 and a circuit 62.

The battery core 61 is configured to provide electric power for operating the electronic atomization device 100. The battery core 61 may be a rechargeable battery core or a disposable battery core.

The circuit 62 integrates a charging circuit and a controller, which may control overall operation of the electronic atomization device 100. The circuit 62 not only controls operations of the battery core 61 and the heater 51, and but also controls operation of another element in the electronic atomization device 100.

In an example, the controller is configured to obtain an initial voltage of the battery core when the battery core starts to be charged; determine whether the initial voltage of the battery core is within one or more preset timing reference voltage ranges; and if the initial voltage of the battery core is within one of the timing reference voltage ranges, control, based on a preset duration corresponding to the timing reference voltage range, the charging circuit to charge the battery core, and control the charging circuit to stop charging the battery core when a charging duration of the battery core reaches the preset duration. The preset duration refers to a duration required to fully charge the battery core when the initial voltage at the start of charging is within the timing reference voltage range. The preset duration is an empirical value determined through testing. It may be understood that a timer is arranged in the controller. When the initial voltage of the battery core is within the timing reference voltage range, the timer is started for timed charging. When a duration of the timed charging reaches a preset duration corresponding to the timing reference voltage range, the charging circuit is controlled to stop charging the battery core.

The one or more timing reference voltage ranges are preset by a user, which are between a pre-charging voltage threshold and a final adjustment voltage of the battery core. The pre-charging voltage threshold is a maximum voltage value in a pre-charging stage in FIG. 1. The final adjustment voltage is a voltage value corresponding to a constant voltage charging stage.

In some embodiments, a timing reference voltage range is set between the pre-charging voltage threshold and the final adjustment voltage of the battery core. A lower limit value of the timing reference voltage range is greater than the pre-charging voltage threshold of the battery core and less than the final adjustment voltage of the battery core. An upper limit value of the timing reference voltage range is the final adjustment voltage of the battery core. Preferably, the lower limit value of the timing reference voltage range is set to a value close to the final adjustment voltage. For example, a pre-charging voltage threshold of a battery core is 3.0V, and a final adjustment voltage is 4.36V, and the lower limit value of a timing reference voltage range may be set to 4.3V, and the upper limit value may be set to 4.36. It should be noted that as the battery core is discharged and charged a plurality of times, the final adjustment voltage value thereof may gradually decrease. Therefore, this factor needs to be considered when the lower limit value of the timing reference voltage range is set.

In another embodiment, to more accurately obtain a preset duration corresponding to each initial voltage value of the battery core at the start of charging, a plurality of timing reference voltage ranges are set between the pre-charging voltage threshold and the final adjustment voltage of the battery core. Two adjacent timing reference voltage ranges share a common endpoint. To be specific, an upper limit value of a previous timing reference voltage range is equal to a lower limit value of a latter timing reference voltage range. In the embodiment, a minimum lower limit value of the plurality of timing reference voltage ranges is greater than the pre-charging voltage threshold of the battery core and less than the final adjustment voltage of the battery core. A maximum upper limit value of the plurality of timing reference voltage ranges is the final adjustment voltage of the battery core. In a preferred implementation, the minimum lower limit value of the plurality of timing reference voltage ranges is set to a value close to the final adjustment voltage. A difference between the upper limit value and the lower limit value of the timing reference voltage range is in a range of 0.01V to 0.2V. The minimum lower limit value of the plurality of timing reference voltage ranges refers to a minimum one of the lower limit values of the plurality of timing reference voltage ranges. The maximum upper limit value of the plurality of timing reference voltage ranges refers to a maximum one of the upper limit values of the plurality of timing reference voltage ranges.

For example, the following 6 timing reference voltage ranges are set for the foregoing battery core: 4.3V to 4.31V, 4.31V to 4.32V, 4.32V to 4.33V, 4.33V to 4.34V, 4.34V to 4.35V, and 4.35V to 4.36V. The foregoing 6 timing reference voltage ranges have the minimum lower limit value of 4.3V and the maximum upper limit value of 4.36V. A test is performed based on each timing reference voltage range to determine a preset duration corresponding to each timing reference voltage range. Results are shown in the following table:

| Timing reference voltage range | Preset duration |
|---|---|
| 4.3V to 4.31 V | 17 minutes |
| 4.31V to 4.32V | 16 minutes |
| 4.32V to 4.33V | 14 minutes |
| 4.33V to 4.34V | 10 minutes |
| 4.34V to 4.35V | 4 minutes |
| 4.35V to 4.36V | 3 minutes |

It may be seen from the table that different timing reference voltage ranges correspond to different preset durations. A range closer to the final adjustment voltage corresponds to a shorter preset duration. For example, when the initial voltage is 4.332V, the initial voltage is compared with each timing reference voltage range, to obtain that the initial voltage is within a 4^{th} timing reference voltage range of 4.33V to 4.34V. Then based on the preset duration of 10 minutes corresponding to the timing reference voltage range, the charging circuit is controlled to charge the battery core. When the charging duration reaches 10 minutes, the controller controls the charging circuit to stop charging the battery core. The plurality of timing reference voltage ranges are set between the pre-charging voltage threshold and the final adjustment voltage of the battery core, so that it may be ensured that the battery is not overcharged or insufficiently charged.

If the initial voltage of the battery core is not within any one timing reference voltage range, that is, the initial voltage of the battery core does not reach the minimum lower limit value of one or more timing reference voltage ranges, the charging circuit is controlled to charge the battery core with a pre-charging current or a constant current. Specifically, if the initial voltage is less than the pre-charging voltage threshold of the battery core, the charging circuit is controlled to first charge the battery core with the pre-charging current and then charge the battery core with the constant current. If the initial voltage is greater than or equal to the pre-charging voltage threshold of the battery core, the charging circuit is controlled to charge the battery core with the constant current. The battery core is charged with the pre-charging current, that is, in the pre-charging stage in FIG. 1. The battery core is charged with the constant current, that is, in a constant current charging stage in FIG. 1.

When the controller controls the charging circuit to charge the battery core with the pre-charging current or the constant current, the voltage of the battery core continues to increase as the charging continues. When the voltage of the battery core is increased to be within one of the timing reference voltage ranges, the charging circuit is controlled to continue charging the battery core based on a preset duration corresponding to the timing reference voltage range, and when a continued charging duration of the battery core reaches the preset duration, the charging circuit is controlled to stop charging the battery core.

In an embodiment of this application, the controller is configured to set a preset battery level indicator to a full charge indicator when controlling the charging circuit to stop charging the battery core (in this case, the battery core is fully charged); and obtain the battery level indicator before the start of charging of the battery core, and control the charging circuit to stop charging the battery core if the battery level indicator is the full charge indicator. In an example, when the battery level indicator is the full charge indicator, the controller generates prompt information to prompt that the battery core is in a fully charged state. A prompting manner includes, but is not limited to, sound, vibration, or the like. In addition, the controller is further configured to obtain the battery level indicator after an aerosol generating device is turned on, start a timer if the battery level indicator is the full charge indicator, and set the battery level indicator to a non-full charge indicator when a timing duration of the timer reaches a preset discharging duration.

In some embodiments, the aerosol generating device is further provided with a detection circuit, configured to detect a voltage of a battery core; and a controller, configured to obtain an initial voltage and a real-time voltage of the battery core through the detection circuit when a charging circuit starts to charge the battery core.

According to the aerosol generating device provided in the embodiments of this application, a controller thereof is configured to obtain the initial voltage of the battery core when the battery core starts to be charged, and if the initial voltage is within one of the preset timing reference voltage ranges, control the charging circuit to charge the battery core based on the preset duration corresponding to the timing reference voltage range, and control the charging circuit to stop charging the battery core when the charging duration reaches the preset duration. According to this application, one or more timing reference voltage ranges and the corresponding preset duration are preset, so that it can be effectively ensured that a battery is fully charged and is not overcharged, thereby improving the endurance of the battery.

### Embodiment II

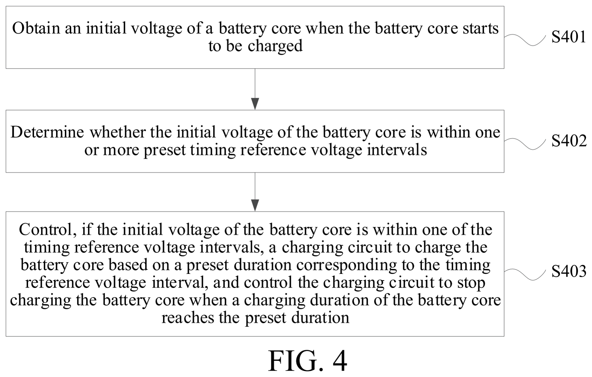

According to an embodiment of this application, a control method for an aerosol generating device is provided. As shown in the figure, FIG. 4 is a flowchart of a control method for an aerosol generating device according to Embodiment II of this application. The aerosol generating device includes a heater, configured to atomize an aerosol-forming substrate to generate an aerosol; a battery core, configured to supply electric power to the heater; and a charging circuit, configured to charge the battery core. The method includes the following steps.

Step S401: Obtain an initial voltage of a battery core when the battery core starts to be charged.

Step S402: Determine whether the initial voltage of the battery core is within one or more preset timing reference voltage ranges.

Step S403: Control, if the initial voltage of the battery core is within one of the timing reference voltage ranges, the charging circuit to charge the battery core based on a preset duration corresponding to the timing reference voltage range, and control the charging circuit to stop charging the battery core when a charging duration of the battery core reaches the preset duration.

Specifically, one or more timing reference voltage ranges are set between a pre-charging voltage threshold and a final adjustment voltage of the battery core. A minimum lower limit value of the one or more timing reference voltage ranges is greater than the pre-charging voltage threshold of the battery core and less than the final adjustment voltage of the battery core. A maximum upper limit value of the one or more timing reference voltage ranges is the final adjustment voltage of the battery core.

If the initial voltage of the battery core is not within any one timing reference voltage range, that is, the initial voltage of the battery core does not reach the minimum lower limit value of the one or more timing reference voltage ranges, the charging circuit is controlled to charge the battery core with a pre-charging current or a constant current until the voltage of the battery core rises to one of the timing reference voltage ranges. In this case, the charging circuit is controlled to continue charging the battery core based on a preset duration corresponding to the timing reference voltage range, and the charging circuit is controlled to stop charging the battery core when a continued charging duration of the battery core reaches the preset duration.

The foregoing control method for an aerosol generating device may be performed by the controller included in the aerosol generating device provided in Embodiment I, which has the same technical concept as the aerosol generating device provided in Embodiment I and has technical features corresponding to the aerosol generating device. For details not described in detail in the embodiments, reference may be made to the description of the controller included in the aerosol generating device in Embodiment I of this application.

It should be noted that the specification of this application and the accompanying drawings thereof illustrate preferred embodiments of this application. However, this application may be implemented in various different forms, and is not limited to the embodiments described in this specification. These embodiments are not intended to be an additional limitation on the content of this application, and are provided for the purpose of providing a more thorough and comprehensive understanding of the content disclosed in this application. In addition, the foregoing technical features are further combined with each other to form various embodiments not listed above, which are all deemed to be within the scope of the description of this application. Further, a person of ordinary skill in the art may make improvements or modifications according to the above descriptions, and all of the improvements and modifications shall fall within the protection scope of the appended claims of this application.

## Claims

1. An aerosol generating device, comprising:
a heater, configured to atomize an aerosol-forming substrate to generate an aerosol;
a battery core, configured to supply electric power to the heater;
a charging circuit, configured to charge the battery core; and
a controller, configured to: obtain an initial voltage of the battery core when the battery core starts to be charged; determine whether the initial voltage of the battery core is within one or more preset timing reference voltage ranges; and if the initial voltage of the battery core is within one of the timing reference voltage ranges, control the charging circuit to charge the battery core for a preset duration corresponding to the timing reference voltage range, and control the charging circuit to stop charging the battery core when a charging duration of the battery core reaches the preset duration.

2. The aerosol generating device according to claim 1, wherein the controller is configured to control the charging circuit to charge the battery core with a pre-charging current or a constant current if the initial voltage is not within said one or more timing reference voltage ranges.

3. The aerosol generating device according to claim 1 or 2, wherein the controller is configured to: when the charging circuit charges the battery core with the pre-charging current or the constant current, control, if a voltage of the battery core rises to be within one of the timing reference voltage ranges, the charging circuit to continue charging the battery core for a preset duration corresponding to the timing reference voltage range, and control the charging circuit to stop charging the battery core when a continued charging duration of the battery core reaches the preset duration.

4. The aerosol generating device according to claim 1, wherein said one or more timing reference voltage ranges are between a pre-charging voltage threshold of the battery core and a final battery adjustment voltage.

5. The aerosol generating device according to claim 1, wherein two adjacent timing reference voltage ranges of the timing reference voltage ranges share a common endpoint.

6. The aerosol generating device according to claim 1, wherein a difference between an upper limit value and a lower limit value of each of the timing reference voltage ranges is in a range of 0.01V to 0.2V.

7. The aerosol generating device according to claim 1, wherein among the timing reference voltage ranges, different timing reference voltage ranges correspond to different preset durations.

8. The aerosol generating device according to claim 1, wherein the controller is configured to set a preset battery level indicator to a full charge indicator when the charging circuit is controlled to stop charging the battery core.

9. The aerosol generating device according to claim 8, wherein the controller is configured to: obtain the battery level indicator before the battery core starts to be charged; and control the charging circuit to stop charging the battery core if the battery level indicator is the full charge indicator.

10. The aerosol generating device according to claim 9, wherein the controller is configured to generate a prompt message if the battery level indicator is the full charge indicator, to indicate that the battery core is in a fully charged state.

11. The aerosol generating device according to claim 1, further comprising a detection circuit, configured to detect a voltage of the battery core, wherein
the controller is configured to obtain the initial voltage of the battery core through the detection circuit when the charging circuit starts to charge the battery core.

12. A control method for an aerosol generating device, wherein:
the aerosol generating device comprises: a heater, configured to atomize an aerosol-forming substrate to generate an aerosol; a battery core, configured to supply electric power to the heater; and a charging circuit, configured to charge the battery core; and
the control method comprises:
obtaining an initial voltage of the battery core when the battery core starts to be charged;
determining whether the initial voltage of the battery core is within one or more preset timing reference voltage ranges; and
if the initial voltage of the battery core is within one of the timing reference voltage ranges, controlling the charging circuit to charge the battery core for a preset duration corresponding to the timing reference voltage range, and controlling the charging circuit to stop charging the battery core when a charging duration of the battery core reaches the preset duration.
